(19) Europäisches Patentamt

European Patent Office

Office européen des brevets

(11) **EP 1 323 232 B1**

(12) **EUROPÄISCHE PATENTSCHRIFT**

(45) Veröffentlichungstag und Bekanntmachung des Hinweises auf die Patenterteilung:
**14.07.2004 Patentblatt 2004/29**

(21) Anmeldenummer: **01978176.4**

(22) Anmeldetag: **20.09.2001**

(51) Int Cl.⁷: **H03H 9/64**, H03H 3/04

(86) Internationale Anmeldenummer:
**PCT/DE2001/003648**

(87) Internationale Veröffentlichungsnummer:
**WO 2002/025811 (28.03.2002 Gazette 2002/12)**

(54) **BAUELEMENT MIT AKUSTISCH AKTIVEM MATERIAL**

ELEMENT MADE OF ACOUSTIC ACTIVE MATERIAL

COMPOSANT MUNI D'UN MATERIAU A ACTIVITE ACOUSTIQUE

(84) Benannte Vertragsstaaten:
**DE FR GB**

(30) Priorität: **25.09.2000 DE 10047379**

(43) Veröffentlichungstag der Anmeldung:
**02.07.2003 Patentblatt 2003/27**

(73) Patentinhaber: **Siemens Aktiengesellschaft
80333 München (DE)**

(72) Erfinder:
- **OSTERTAG, Thomas
  85464 Finsing (DE)**
- **KORDEN, Christian
  81247 München (DE)**
- **RUILE, Werner
  80636 München (DE)**

(56) Entgegenhaltungen:
EP-A- 0 834 989          US-A- 4 464 639
US-A- 5 992 215

- R E NEWNHAM ET A AMIN: "SMART SYSTEMS: MICROPHONES, FISH FARMING, AND BEYOND" CHEMTECH, [Online] vol. 29, no. 12, 1 December 1999 (1999-12-01), pages 38-46, XP002187889 Retrieved from the Internet: <URL:http://pubs.acs.org/hotartcl/chemtech/99/dec/newn.html> [retrieved on 2002-01-21]
- FOUSEK J: "Domain investigations: a select review" , APPLICATIONS OF FERROELECTRICS, 1992. ISAF '92., PROCEEDINGS OF THE EIGHTH IEEE INTERNATIONAL SYMPOSIUM ON GREENVILLE, SC, USA 30 AUG.-2 SEPT. 1992, NEW YORK, NY, USA,IEEE, US, PAGE(S) 171-178 XP010102771 ISBN: 0-7803-0465-9 page 173, left-hand column, line 18 -page 174, left-hand column, line 4
- KRUPANIDHI S B ET AL: "Studies on structural and electrical properties of barium strontium titanate thin films developed by metallo-organic decomposition" THIN SOLID FILMS, ELSEVIER-SEQUOIA S.A. LAUSANNE, CH, vol. 305, no. 1-2, 1 August 1997 (1997-08-01), pages 144-156, XP004088975 ISSN: 0040-6090

**Beschreibung**

Die Erfindung betrifft ein Bauelement in Form eines Filters mit einem akustisch aktivem Material sowie ein Verfahren zum Betrieb eines solchen Bauelementes.

Da die Normen bei mobilen Telekommunikationssystamen weltweit verschieden sind, aber auch innerhalb eines Sendegebietes je nach benötigter Bandbreite immer mehr verschiedene Normen angeboten werden, möchte man ein mobiles Telekommunikationsgerät haben, das alle diese Normen oder zumindest einen Teil davon abdecken kann. Dabei besteht das Problem, dass die Sende- und Empfangsbänder in verschiedenen Frequenzen liegen und darüber hinaus noch verschiedene Bandbreiten haben. Deshalb ist ein elektronisch abstimmbares Filter für Telekommunikationsgeräte erstrebenswert, so dass man per Software das Telefon auf die gewünschte Norm einstellen kann.

Bisher gibt es keine abstimmbaren Filter, die das obige Problem lösen. Man behilft sich heute damit, die in der Telekommunikationstechnik bewährten Oberflächenwellenfilter (OFW-Filter) einzusetzen und zwischen diesen Filtern je nach Bedarf hin- und herzuschalten. OFW-Bauelemente kommen in vielen Variationen als funkabfragbare oder selbstsendende Sensoren, Identifikationsmarken oder Filter zum Einsatz. Ausführungsformen nach dem Stand der Technik sind zum Beispiel in DE 198 60 058 C1, EP 0 746 775 B1, EP 0 655 701 B1, EP 0 651 344 B1, EP 0 619 906 B1, US 5 691 698, US 5 841 214, US 5 966 008, US 5 910 779, US 6 029 324, US 6 084 503 offenbart.

OFW-Filter selbst sind wegen ihrer Stabilität bekannt und deshalb leider nicht oder nur in sehr engen Grenzen abstimmbar. Der Einsatz mehrerer Filter in einem Gerät führt natürlich zu größerem Platzbedarf und erhöhten Kosten, da für jede Norm ein eigenes Filter gebraucht wird. Weil diese OFW-Filter zudem nicht in die Halbleitertechnik integrierbar sind, müssen Hybridlösungen verfolgt werden.

Um wenigstens von diesen Hybridlösungen wegzukommen, werden immer wieder FBARS (Film Bulk Acoustic Resonators), die mit akustischen Volumenwellen arbeiten, vorgeschlagen, die, zumindest zum Teil, CMOS-kompatibel hergestellt werden können. Aber auch hier wird für jede Norm ein eigenes oder sogar mehrere Filter benötigt. Das Hautproblem bei dieser Lösung besteht aber darin, dass die erforderliche Frequenzgenauigkeit herstellungstechnisch nicht beherrscht wird, so dass eine Massenfertigung und damit niedrige Preise nicht verfügbar sind.

Aus EP 0 834 989 A2 ist ein FBAR bekannt, dessen elastische Konstanten zumindest teilweise veränderbar sind. Diese Veränderungen sind allerdings so klein, dass damit Fertigungsschwankungen nicht aufgefangen werden können, geschweige denn ein abstimmbares Filter realisiert werden kann.

R. E. Newnham, A. Amin: "Smart Systems: Microphones, fish Farming, and beyond" CHEMTECH, [Online] Band 29, Nr. 12, 01. Dezember 1999, Seiten 38 bis 46, American Chemical Society, offenbart piezoelektrische Keramiken mit Zusammensetzungen nahe dem zweiten Phasenübergang. Damit wird in Sensoren Belastung gemessen und in Aktoren Belastung erzeugt.

US-A-4,464,639 beschreibt die Eigenschaften von ferroelektrischen Kristallen, insbesondere den Zusammenhang zwischen ferroelektrischem und piezoelektrischem Zustand in solchen Kristallen und die Veränderbarkeit von Druck und Belastung durch elektrische Felder. Weiterhin wird der Phasenübergang von der ferroelektrischen zur paraelektrischen Phase beim Curie-Punkt beschrieben. Es wird ein Verfahren zum Einstellen der Frequenzeigenschaften eines Kristalls durch Polarisierung über der Übergangstemperatur und Betrieb unterhalb derselben beschrieben, wobei die doppelte Frequenz der Interdigitalwandler erzielt werden kann. Schließlich wird eine Anwendung für ein Filter gezeigt, welches oberhalb der Übergangstemperatur getunt unterhalb derselben betrieben wird.

Davon ausgehend liegt der Erfindung die Aufgabe zugrunde, ein Filter vorzuschlagen, dessen akustische Konstanten im Betrieb in einem solchen Maße veränderbar sind, dass es sich mit Hilfe einer Steuerung auf den Frequenzbereich der jeweils gewünschten Telekommunikationsnorm einstellen lässt. Unter akustischen Konstanten werden dabei insbesondere die elastischen Konstanten, wie die Steifigkeit, und die Dichte verstanden. Diese Materialkonstanten bestimmen die Schallgeschwindigkeit und damit die Frequenz einer akustischen Schwingung im akustisch aktiven Material.

Die Aufgabe wird durch ein Filter und ein Verfahren mit den Merkmalen der unabhängigen Patentansprüche gelöst.

Der Erfindung liegt die Erkenntnis zugrunde, dass sich eine große Veränderung der akustischen Konstanten an einem Phasenübergangspunkt und/oder in der Nähe eines derartigen Punktes des Materials erzielen lässt. Durch die Veränderung der akustischen Konstanten des akustisch aktiven Materials lässt sich die Frequenz der darin laufenden akustischen Wellen in gewünschter Weise einstellen. Dies gilt sowohl für Oberflächenals auch für Volumenwellen, so dass das Filter wahlweise ausgebildet werden kann, um mit Oberflächen- und/oder Volumenwellen zu arbeiten. Ist das akustisch aktive Material des Filters zumindest teilweise ein piezoelektrisches Material, so kann auf die bekannten Techniken der Umwandlung elektromagnetischer Wellen in akustische Wellen zurückgegriffen werden. Hierfür ist insbesondere der Einsatz von Interdigitalwandlern für Oberflächenwellenbauelemente oder das Aufbringen von Elektroden auf zwei gegenüberliegenden Seiten des akustisch aktiven Materials bei Volumenwellenbauelementen denkbar.

Die Nähe zum Phasenübergangspunkt ist gegeben, wenn sich die akustischen Konstanten des akustisch aktiven Materials so beeinflussen lassen, dass sich eine Geschwindigkeitsänderung von etwa mindestens 0,5 % ergibt. Dies reicht aus, um Fertigungsschwankungen des Resonators auszugleichen. Für weiterreichende Anwendungen ist aber eine minimale Geschwindigkeitsänderung von 1 %, 5 % und insbesondere 10 % bevorzugt.

Bei Einsatz eines piezoelektrischen Materials als akustisch aktives Material wird vorzugsweise als Phasenübergangspunkt der Phasenübergangspunkt zwischen der ferroelektrischen Phase und der parelektrischen Phase gewählt. Hier sind die akustischen Konstanten des akustisch aktiven Materials, insbesondere durch die Änderung der piezoelektrischen Kopplung, in einem weiten Rahmen veränderbar. Um weiterhin den piezoelektrischen Effekt zur Ankopplung elektromagnetischer Wellen an die akustischen Wellen im akustisch aktiven Material ausnutzen zu können, sollte dabei bevorzugt auf der Seite der ferroelektrischen Phase des Phasenübergangspunktes gearbeitet werden.

Befindet sich ein räumlich definierter Teil des akustisch aktiven Materials in der ersten Phase, während sich ein anderer. räumlich definierter Teil in der zweiten Phase befindet, so kann die gemäß der Kramers-Kronig-Relation auftretende Dämpfung direkt am Phasenübergangspunkt vermieden werden.

Vorzugsweise enthält das Filter Mittel zur Veränderung der akustischen Konstanten des akustisch aktiven Materials und/oder Anschlüsse für solche Mittel. Diese Mittel können zum Beispiel Elemente zum Anlegen einer elektrischen Spannung, insbesondere an das akustisch aktive Material, aufweisen, mittels derer die akustischen Konstanten des Materials veränderbar sind. Diese Elemente zum Anlegen einer elektrischen Spannung können zum Beispiel in Form von Elektroden ausgebildet sein, die an dem Filter und insbesondere an dem akustisch aktiven Material angeordnet sind. Für Wechselspannungen sind aber auch Elemente vorstellbar, die induktiv arbeiten.

Die Mittel zur Veränderung der akustischen Konstanten können auch Elemente zum Einstellen der Temperatur, insbesondere in dem akustisch aktiven Material, aufweisen, mittels derer die akustischen Konstanten des akustisch aktiven Materials veränderbar sind. Solche Elemente können in jeglicher Art von Heizungs- und/oder Kühlvorrichtungen ausgebildet sein. Insbesondere ist die Anordnung von Peltier-Elementen denkbar.

Weiterhin können die Mittel zur Veränderung der akustischen Konstanten auch Elemente zum Einstellen weiterer thermodynamischer Größen, wie etwa des Drucks, insbesondere in dem akustisch aktiven Material, aufweisen, mittels derer die akustischen Konstanten des akustisch aktiven Materials veränderbar sind.

Das Filter wird vorzugsweise als Oberflächenwellenbauelement, Volumenwellenbauelement und/oder elektrostatisch gekoppelter Membranschwinger ausgeführt und, insbesondere hinsichtlich seines akustisch aktiven Materials, so dimensioniert, dass es als Filter in den gewünschten Frequenzbereichen einsetzbar ist.

In einem erfindungsgemäßen Verfahren zum Betrieb eines Bauelementes mit einem akustisch aktiven Material werden die akustischen Konstanten des akustisch aktiven Materials verändert, wobei sich das akustisch aktive Material zumindest teilweise an einem Phasenübergangspunkt und/oder in der Nähe eines Phasenübergangspunktes befindet.

In diesem Verfahren wird vorteilhafterweise ein Filter der oben beschriebenen Art eingesetzt.

Weitere wesentliche Merkmale und Vorteile der Erfindung ergeben sich aus der Beschreibung eines Ausführungsbeispiels anhand der Zeichnung. Dabei zeigt

Figur 1 ein Filter mit akustisch aktivem Material und

Figur 2 eine Schaltung zur Regelung dieses Filters.

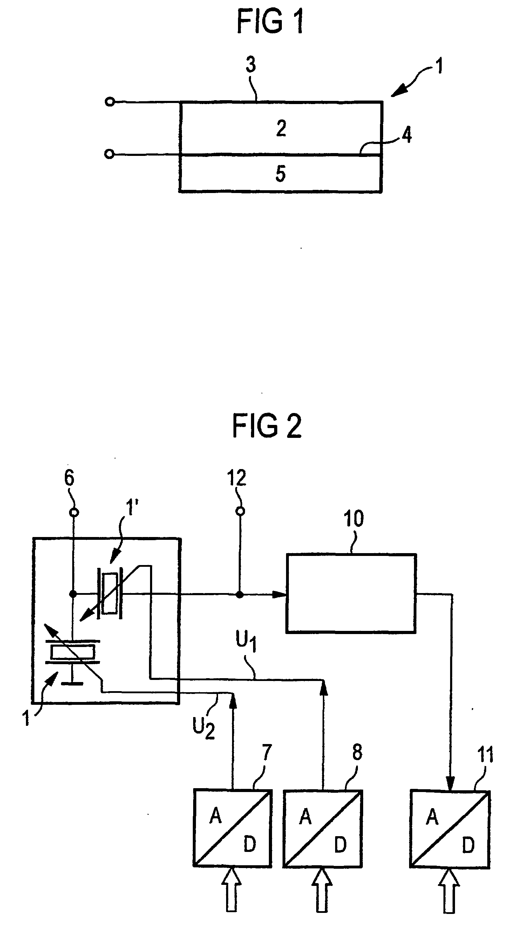

In Figur 1 erkennt man ein Filter in Form eines Bauelementes 1 mit einem akustisch aktiven Material 2. Das akustisch aktive Material 2 besteht aus einer piezoelektrischen Substanz wie zum Beispiel $LiNbO_3$, $LiTaO_3$, $Bi_{12}GeO_{20}$, $Li_2B_4O_7$, $AlPO_4$, GaAs, ZnO und/oder Quarz.

Das akustisch aktive Material befindet sich zumindest teilweise an einem Phasenübergangspunkt und/oder in der Nähe eines Phasenübergangspunktes. Dieser Phasenübergangspunkt ist insbesondere der Curiepunkt bei ferroelektrischen Materialien. Es ist bekannt, dass sich die dielektrischen Konstanten $\varepsilon$ in der Nähe des Curiepunktes mit der Temperatur, aber auch mit dem angelegten elektrischen Feld sehr stark ändert. Diese Änderung verändert mittels der piezoelektrischen Kopplung die Steifigkeit $c$ des Materials:

$$c = c_0 + \frac{d^2}{\varepsilon}.$$

Dabei steht $c_0$ als Steifigkeit des akustischen Materials ohne piezoelektrischen Effekt und d für die piezoelektrischen Konstanten des akustisch aktiven Materials. Die dielektrischen Konstanten $\varepsilon$, die Steifigkeiten c, $c_0$ und die piezoelektrischen Konstanten $d$ sind in der Regel Tensoren.

Ist also der Wert für $\varepsilon$ sehr groß, wie es in der Nähe des Curiepunktes der Fall ist, so fällt die piezoelektrische Versteifung (piezoelectric stiffening)

$$\frac{d^2}{\varepsilon},$$

die das akustische Material durch den piezoelektrischen Effekt erfährt, weg und man erhält die Steifigkeiten, als ob kein Piezoeffekt vorhanden wäre. Sinkt umgekehrt $\varepsilon$ ab, so tritt eine verstärkte Steifigkeit auf. Hierbei wird das akustisch aktive Material in seinem gesamten betroffenen Volumen selbst verändert.

Mit dieser Veränderbarkeit der akustischen Konstanten ist eine große Instabilität verbunden, insbesondere was die Temperatur betrifft. Eine weitere Instabilität kommt von der Fertigung, aber auch von einer eventuellen Alterung. Um alle diese Instabilitäten zu beherrschen, ist eine feste Referenz notwendig, auf die man sich in einer Regelung beziehen kann. Dabei sind die Zeitkonstanten für die Instabilitäten sehr unterschiedlich. Die fertigungsbedingte Instabilität ist zeitunabhängig und kann deshalb durch Korrekturwerte $U_{\text{Fertigung}}$ für die anzulegende Spannung U kompensiert werden, die in einem festen Speicher abgelegt werden. Die Korrekturwerte zur Kompensation der Alterungsstabilität $U_{\text{Alterung}}$ brauchen nur von Zeit zu Zeit auf den neuesten Stand gebracht werden. In diesen Alterungseffekten sind dann natürlich auch alle Effekte eingeschlossen, die von der Elektronik selbst herkommen. Die Korrekturwerte zur Kompensation der Temperatur $U_{\text{Temperatur}}$ müssen dagegen laufend erneuert werden, da nicht nur die sich langsam veränderbare Umgebungstemperatur eine Rolle spielt, sondern die Temperatur sich auch im Betrieb selbst verändern kann (Selbsterwärmung).

Neben diesen Korrekturspannungen muss im Falle eines durchstimmbaren Filters schließlich auch die Frequenz selbst durchgestimmt werden können, um das entsprechende Frequenzband bzw. die Sollfrequenz $f_{\text{soll}}$ einstellen zu können. Dafür wird eine Spannung $U_{\text{fsoll}}$ angelegt.

Insgesamt wird an den beiden am akustisch aktiven Material 2 flächig angeordneten Elektroden 3, 4 die Überlagerung aller oben aufgeführten Spannungen angelegt:

$$U_{\text{FBAR}} = U_{\text{fsoll}} + U_{\text{Alterung}} + U_{\text{Fertigung}} + U_{\text{Temperatur}} + U_{\text{Rest}}$$

Die von dem als FBAR ausgeführten Bauelement 1 erzeugte Frequenz $f_{\text{ist}}$ wird auf eine feste Referenzfrequenz $f_{\text{Referenz}}$ bezogen. Die Spannung $U_{\text{FBAR}}$ wird dabei so lange nachgeregelt, bis $f_{\text{ist}} - f_{\text{Referenz}}$ den gewünschten Wert $f_{\text{soll}} - f_{\text{Referenz}}$ annimmt. Dabei werden auch noch alle etwaigen restlichen Effekte kompensiert, die oben nicht speziell aufgeführt wurden.

An dem akustisch aktiven Material 2 ist weiterhin ein Peltier-Element 5 angeordnet, über das eine Temperaturkompensation durch Heizen oder Kühlen des akustisch aktiven Materials erfolgt. Bei guter thermischer Isolierung und kleiner Wärmekapazität (Membran) ist dabei die Zeitkonstante für die Erhitzung bzw. Abkühlung des akustisch aktiven Materials klein.

Neben dem Einsatz von FBARS als Volumendickenschwingern besteht eine Weiterbildung der Erfindung darin, die akustisch veränderbare Schicht in elektrostatisch gekoppelten Membranschwingern (MEMS) einzusetzen, wie sie zum Beispiel aus Clark T.-C. Nguyen: "Micromachining Technologies for Miniaturized Communication Devices", Proceedings of SPIE, Santa Clara, California, 1998, S. 24-38 sind. Dabei wird die Steifigkeit in der schwingenden Membran verändert und damit ebenfalls eine Frequenzverstimmung erzielt. Der Einsatz dieser Resonatoren wird eher im Zwischenfrequenzbereich liegen, im Gegensatz zu Dickenschwingern, die im Frontendbereich eingesetzt werden. Mit dieser Weiterbildung ergibt sich nicht nur für Frontendfilter, sondern auch für Zwischenfrequenzfilter die Möglichkeit zur Integration in die Halbleitertechnik mit allen damit verbundenen Vorteilen. Frontend- und Zwischenfrequenzfilter können sogar auf einem Chip mit einer zum Teil gemeinsam genutzten Steuerung und Regelung hergestellt werden.

Ein Beispiel für eine Regelung zeigt Abbildung 2. Dabei sind zwei erfindungsgemäße Bauelemente 1, 1' als Eintorresonatoren ausgeführt und zu einem abstimmbaren Laddertypefilter angeordnet. Über einen Eingang 6 wird ein Eingangssignal in das abstimmbare Laddertypefilter eingegeben, in dem ein Bauelement 1' im Signalweg in Serie geschaltet ist, während das andere Bauelement 1 in Parallelschaltung zur Masse führt. Die akustischen Konstanten der beiden Bauelemente und damit deren Frequenzen werden in der oben beschriebenen Weise über Steuerspannungen $U_1$, $U_2$ geregelt. Die Steuerspannungen $U_1$, $U_2$ werden über D/A-Wandler 7, 8 von einem Mikrocontroller 9 geregelt. An einem Ausgang 12 des abstimmbaren Laddertypefilters kann ein in gewünschter Weise gefiltertes Nutzsignal abgegriffen werden.

Am Ausgang des zum Signalweg in Serie geschalteten Bauelementes 1' befindet sich eine Vorrichtung 10 zur Messung der Empfangsfeldstärke. Die von der Vorrichtung 10 zur Messung der Empfangsfeldstärke gemessene Empfangsfeldstärke wird über einen A/D-Wandler 11 zum Mikrokontroller 9 geführt.

Das aus den Bauelementen 1, 1' aufgebaute und dem Empfangszug vorgeschaltete Laddertypefilter wird vom Mikrokontroller 9 in seiner Mittenfrequenz so lange verstimmt, bis das Maximum der Empfangsfeldstärke am Ausgang der Vorrichtung 10 zur Messung der Empfangsfeldstärke erreicht wird.

Auch ist nicht unbedingt das gesamte für die derzeitige mobile Telekommunikation von 800 MHz bis 2,5 GHz reichende Frequenzband lückenlos abzudecken. Es genügt, die Bereiche um 900 MHz und 2 GHz abzudecken. Hier bietet sich bei den FBARS die Verwendung von harmonischen Oberwellen an. Der untere Frequenzbereich wird von der Grundwelle abgedeckt, während für den oberen Bereich die erste harmonische Schwingung eingesetzt wird. Durch eine geeignete Elektrodenkonfiguration in der Membranstruktur eines FBARS und eine entsprechende Ansteuerung kann eine Modenselektion erreicht werden, also das Filter bevorzugt entweder auf der Grundwelle oder der einer harmonischen Schwingung betrieben werden.

**Patentansprüche**

1.  Filter, insbesondere für ein Telekommunikationsgerät, mit einem akustisch aktiven Material (2), dessen akustische Konstanten zumindest teilweise veränderbar sind,
    **dadurch gekennzeichnet,**
    **dass** die akustischen Konstanten des akustisch aktiven Materials (2) zum Abstimmen des Filters im Betrieb veränderbar sind, wobei das akustisch aktive Material zumindest teilweise an einem Phasenübergangspunkt und/ oder in der Nähe eines Phasenübergangspunktes betrieben wird.

2.  Filter nach Anspruch 1,
    **dadurch gekennzeichnet,**
    **dass** das akustisch aktive Material (2) zumindest teilweise ein piezoelektrisches Material ist.

3.  Filter nach Anspruch 2,
    **dadurch gekennzeichnet,**
    **dass** der Phasenübergangspunkt der Phasenübergangspunkt zwischen der ferroelektrischen und der parelektrischen Phase ist.

4.  Filter nach zumindest einem der vorhergehenden Ansprüche,
    **dadurch gekennzeichnet,**
    **dass** ein Teil des akustisch aktiven Materials (2) sich in der einen Phase befindet, während ein anderer Teil des akustisch aktiven Materials (2) sich in der anderen Phase befindet.

5.  Filter nach zumindest einem der vorhergehenden Ansprüche,
    **dadurch gekennzeichnet,**
    **dass** das Bauelement (1) Mittel (3, 4, 5) zur Veränderung der akustischen Konstanten und/oder Anschlüsse für solche Mittel aufweist.

6.  Filter nach zumindest Anspruch 5,
    **dadurch gekennzeichnet,**
    **dass** die Mittel (3, 4) zur Veränderung der akustischen Konstanten Elemente zum Anlegen einer elektrischen Spannung aufweisen, mittels derer die akustischen Konstanten des akustisch aktiven Materials (2) veränderbar sind.

7.  Filter nach zumindest Anspruch 5,
    **dadurch gekennzeichnet,**
    **dass** die Mittel (5) zur Veränderung der akustischen Konstanten Elemente zum Einstellen der Temperatur aufweisen, mittels derer die akustischen Konstanten des akustisch aktiven Materials (2) veränderbar sind.

8.  Filter nach zumindest einem der vorhergehenden Ansprüche,
    **dadurch gekennzeichnet,**
    **dass** das Bauelement (1) ein Oberflächenwellenbauelement, ein Volumenwellenbauelement und/oder ein Membranschwinger ist.

9.  Verfahren zum Betrieb eines Filters (1) mit einem akustisch aktiven Material (2), bei dem

    -   die akustischen Konstanten des akustisch aktiven Materials (2) zum Abstimmen des Filters im Betrieb verändert werden und
    -   das akustisch aktive Material (2) zum Abstimmen des Filters im Betrieb zumindest teilweise an einem Phasenübergangspunkt und/oder in der Nähe eines Phasenübergangspunktes betrieben wird.

**Revendications**

1.  Filtre, en particulier pour un appareil de télécommunication, avec un matériau (2) à activité acoustique, dont les constantes acoustiques sont au moins partiellement modifiables,
    **caractérisé en ce que**
    les constantes acoustiques du matériau (2) à activité acoustique peuvent être modifiées en service pour syntoniser le filtre, le matériau à activité acoustique étant utilisé au moins partiellement en un point de transition de phase et/ou à proximité d'un point de transition de phase.

2.  Filtre selon la revendication 1,
    **caractérisé en ce que**,
    le matériau (2) à activité acoustique est au moins partiellement un matériau piézo-électrique.

3.  Filtre selon la revendication 2,
    **caractérisé en ce que**,
    le point de transition de phase est le point de transition de phase entre la phase ferroélectrique et la phase paraélectrique.

4.  Filtre selon au moins l'une quelconque des revendications précédentes,
    **caractérisé en ce que**,
    une partie du matériau (2) à activité acoustique se trouve dans une phase, alors qu'une autre partie du matériau (2) à activité acoustique se trouve dans l'autre phase.

5.  Filtre selon au moins l'une quelconque des revendications précédentes,
    **caractérisé en ce que**,
    le composant (1) présente des moyens (3, 4, 5) pour la modification des constantes acoustiques et/ou des branchements pour ces moyens.

6.  Filtre selon au moins la revendication 5,
    **caractérisé en ce que**,
    les moyens (3, 4) présentent pour la modification des constantes acoustiques des éléments pour l'application d'une tension électrique, au moyen desquels les constantes acoustiques du matériau (2) à activité acoustique peuvent être modifiées.

7.  Filtre selon au moins la revendication 5,
    **caractérisé en ce que**,
    les moyens (5) présentent pour la modification des constantes acoustiques des éléments pour le réglage de la température, au moyen desquels les constantes acoustiques du matériau (2) à activité acoustique peuvent être modifiées.

8.  Filtre selon au moins l'une quelconque des revendications précédentes,
    **caractérisé en ce que**,
    le composant (1) est un composant d'ondes superficielles, un composant d'ondes de volume et/ou un vibreur à membrane.

9.  Procédé pour l'utilisation d'un filtre (1) avec un matériau (2) à activité acoustique, dans lequel

    -   les constantes acoustiques du matériau (2) à activité acoustique sont modifiées en service pour la syntonisation du filtre en service et
    -   le matériau (2) à activité acoustique est utilisé pour la syntonisation du filtre en service au moins partiellement en un point de transition de phase et/ou à proximité d'un point de transition de phase.

**Claims**

1.  A filter, in particular for a telecommunications device, having an acoustically active material (2) whose acoustic constants are at least partially modifiable,
    **characterised in that**
    the acoustic constants of the acoustically active material (2) are modifiable in order to tune the filter during operation, the acoustically active material being operated at least partially at a phase transition point and/or in proximity to a phase transition point.

2.  The filter according to claim 1,
    **characterised in that**
    the acoustically active material (2) is at least partially a piezoelectric material.

3.  The filter according to claim 2,
    **characterised in that**
    the phase transition point is the phase transition point between the ferroelectric and the parelectric phase.

4.  The filter according to at least one of the preceding claims,
    **characterised in that**
    a part of the acoustically active material (2) is located in one phase, while another part of the acoustically active material (2) is located in the other phase.

5.  The filter according to at least one of the preceding claims,
    **characterised in that** the component (1) comprises means (3, 4, 5) for modifying the acoustic constants and/or terminals for such means.

6.  The filter according to at least claim 5,
    **characterised in that**
    the means (3, 4) for modifying the acoustic constants comprise elements for applying an electric voltage, by means of which the acoustic constants of the acoustically active material (2) can be modified.

7.  The filter according to at least claim 5,
    **characterised in that**
    the means (5) for modifying the acoustic constants comprise elements for setting the temperature, by means of which the acoustic constants of the acoustically active material (2) can be modified.

8.  The filter according to at least one of the preceding claims,
    **characterised in that**
    the component (1) is a surface acoustic wave component, a volume wave component and/or a diaphragm oscillator.

9.  A method for operating a filter (1) having an acoustically active material (2), wherein

    -   the acoustic constants of the acoustically active material (2) are modified in order to tune the filter during operation and
    -   the acoustically active material (2) for tuning the filter during operation is operated at least partially at a phase transition point and/or in proximity to a phase transition point.

# FIG 1

# FIG 2